Europäisches Patentamt

European Patent Office

Office européen des brevets

(11) Publication number: **0 155 720**
**B1**

# EUROPEAN PATENT SPECIFICATION

(45) Date of publication of patent specification: **03.01.90**

(51) Int. Cl.⁵: **G 05 F 3/26**

(21) Application number: **85200255.9**

(22) Date of filing: **25.02.85**

(54) **Cascode current source arrangement.**

(30) Priority: **29.02.84 NL 8400637**

(43) Date of publication of application:
**25.09.85 Bulletin 85/39**

(45) Publication of the grant of the patent:
**03.01.90 Bulletin 90/01**

(84) Designated Contracting States:
**CH DE FR GB IT LI**

(56) References cited:
**WO-A-82/00550**
**US-A-3 936 725**

**ELECTRONICS LETTERS, vol. 12, no. 15, 22nd
July 1976, pages 389-390, Hitchin, Herts, GB;
B.L. HART et al.: "D.C. matching errors in the
Wilson current source"**

**ELECTRONICS LETTERS, vol. 12, no. 7, 1st April
1976, pages 174-175, Hitchin, Herts, GB; B.L.
HART et al.: " 'Early-intercept voltage': A
parameter of voltage-driven B.J.T.s"**

**JAEGER: "A high output resistance current
source, IEEE Journal of Solid State Circuit, Aug.
1974, pp. 192-194**

(73) Proprietor: **N.V. Philips' Gloeilampenfabrieken**
**Groenewoudseweg 1**
**NL-5621 BA Eindhoven (NL)**

(72) Inventor: **van Tuijl, Adrianus Johannes Maria**
**c/o INT. OCTROOIBUREAU B.V. Prof. Holstlaan 6**
**NL-5656 AA Eindhoven (NL)**

(74) Representative: **Peters, Rudolf Johannes et al**
**INTERNATIONAAL OCTROOIBUREAU B.V. Prof.
Holstlaan 6**
**NL-5656 AA Eindhoven (NL)**

(56) References cited:

**KROEBEL: "Grundschaltung der analogen
integrierten Technik", Radio Fernsehen
Elektronik, 27 (1978), H. 10, pp 621-625**

Courier Press, Leamington Spa, England.

## Description

The invention relates to a cascode current-source arrangement comprising a first and a second transistor whose collector-emitter paths are arranged in series between a first terminal and a common second terminal, and a third transistor connected as a diode, whose base is connected to the base of the second transistor and whose emitter is connected to the common second terminal.

Such cascode current-source arrangements are generally applicable in integrated circuits and are in particular suitable for use in amplifier circuits as described in European Patent Application 85200243.5 filed, simultaneously with the present Application.

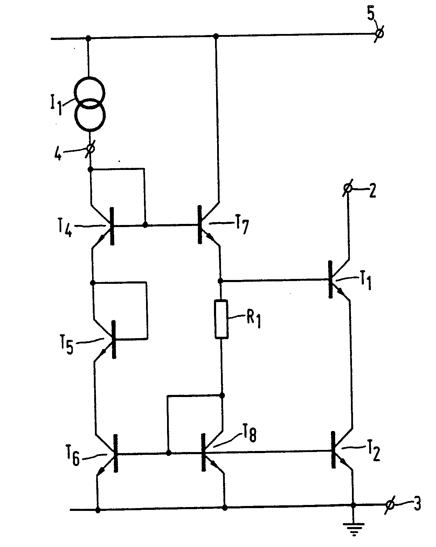

Such a current-source arrangement is known from Figure 2 of United States Patent Specification 4,345,217. The collector current of the second transistor is defined by connecting a diode-connected transistor in parallel with the base-emitter junction of this second transistor. The collector current of the second transistor then also flows through the collector-emitter path of the first transistor, whose base is at a reference voltage. As a result of this reference voltage the collector-emitter voltage of the second transistor is then also constant. From United States Patent Specification 3,936,725 it is known that this can be reference voltage can be generated by arranging a second diode-connected transistor in series with the first diode-connected transistor, the base of said second diode-connected transistor being connected to the base of the first transistor. The collector-emitter voltage of the second transistor is then equal to one base-emitter voltage. A disadvantage of this arrangement is that, if the collector of the second transistor is used as a signal input, the lowest voltage attainable on the collector of the first transistor is equal to the sum of the base-emitter voltage, which appears across the collector-emitter path of the second transistor, and the saturation voltage of the first transistor. However, in order to obtain a maximum voltage swing the collector voltage of the second transistor must be as low as possible. This is of particular importance if the current-source arrangement is used with low supply voltages. Another disadvantage of this arrangement is that owing to the difference in the collector-emitter voltages of the diode-connected transistor and the second transistor the current flowing through the second transistor is not exactly equal to the current through the diode. Therefore, it is the object of the invention to provide a cascode current-source arrangement which does not have the said disadvantages. According to the invention, as claimed, a cascode current-source arrangement of a type as specified in the opening paragraph is characterized in that it further comprises a first input current path which comprises, between a third terminal and the common second terminal, the series arrangement of a fourth transistor connected as a diode, a diode and the collector-emitter path of a fifth transistor, and a second current path which comprises, between the base of the fourth transistor, and the common second terminal, the series arrangement of the base-emitter path of a sixth transistor having a collector coupled to a supply voltage terminal, a resistor and the base-emitter path of the third transistor, whose base is further connected to the base of the fifth transistor, and the base of the first transistor is connected to that end of the resistor which is remote from the third transistor. In this arrangement in accordance with the invention the collector-emitter voltage of the second transistor is substantially equal to the voltage across the resistor in the second current path. The voltage across this resistor can be made substantially lower than one base-emitter voltage, so that the collector of the first transistor can be driven to a very low voltage. Moreover, the voltage across this resistor is equal to the collector-emitter voltage of the fifth transistor, so that the collector-emitter voltage of the second transistor is equal to the collector-emitter voltage of the fifth transistor in the input current path, which transistors have also equal base-emitter voltages. Therefore, the ratio between the currents through the second and the fifth transistor is defined accurately by the ratio between the emitter areas of these transistors.

The invention will now be described in more detail, by way of example, with reference to the accompanying drawing, which shows a cascode current-source arrangement in accordance with the invention.

The arrangement comprises a transistor $T_1$ and a transistor $T_2$ connected in cascode, the collector-emitter paths of these transistors being connected in series between an output terminal 2 and the negative power-supply terminal 3, in the present case earth. A load may be connected to terminal 2. The arrangement further comprises a current-mirror circuit which comprises an input current path which comprises, between an input terminal 4 and the power-supply terminal 3, the series arrangement of a diode-connected transistor $T_4$, a diode-connected transistor $T_5$, and the collector-emitter path of a transistor $T_6$. A current source $I_1 = I$ is connected to input terminal 4 and to the positive power-supply terminal 5. The current-mirror circuit further comprises a second current path which comprises, between the positive power-supply terminal 5 and the negative power-supply terminal 3, the series arrangement of the collector-emitter path of a transistor $T_7$, whose base is connected to the base of the transistor $T_4$, a resistor $R_1 = R$, and a diode-connected transistor $T_8$, whose base is connected to the base of transistor $T_6$ and to the base of transistor $T_2$.

If the emitter areas of the transistors $T_4$, $T_5$, and $T_6$ are, for example, twice as large as the emitter area of the transistor $T_7$ and transistor $T_8$, a current which is substantially equal to I/2 will flow in the second current path as a result of the commoned bases of the transistors $T_4$ and $T_7$ and the commoned bases of the transistors $T_6$ and $T_8$. Since transistors $T_4$ and $T_7$ have the same base voltage the voltages between said commoned bases and the negative power-supply terminal 3 in the input current path and the second current path are equal. Therefore, the following equation is valid for this arrangement:

$$V_{BET4}+V_{BET5}+V_{CET6}=V_{BET7}+V_R+V_{BET8} \tag{1}$$

where the $V_{BE}$'s are the base-emitter voltages of the relevant transistors, $V_{CET6}$ is the collector-emitter voltage of transistor $T_6$, and $V_R$ is the voltage across the resistor $R_1$. Owing to the ratios between the currents and between the emitter areas of the transistors $T_4$, $T_5$ and $T_6$ and the transistors $T_7$ and $T_8$, the base-emitter voltages of the transistors $T_4$, $T_5$, $T_7$ and $T_8$ are equal, so that it follows from equation (1) that

$$V_{CET6}=V_R \tag{2}$$

If the emitter areas of the transistors $T_1$ and $T_2$ are, for example, twice as large as those of the transistors $T_4$, $T_5$ and $T_6$, the current flowing through transistors $T_1$ and $T_2$ will be twice as large as the current in the input current path. Moreover, the voltage between the base of transistor $T_4$ and the negative power-supply terminal 3 satisfies the following equation:

$$V_{CET6}+V_{BET5}+V_{BET4}=V_{BET7}+V_{BET1}+V_{CET2} \tag{3}$$

Owing to the ratios between the currents and between the emitter areas of the transistors $T_4$, $T_5$, $T_7$ and $T_1$ it follows from equation (2) that

$$V_{CET6}=V_{CET2} \tag{4}$$

Since the collector-emitter voltages are equal the ratio between the currents in the transistors $T_2$ and $T_6$ depends only on the ratio between the emitter areas, so that in the present example the current in transistor $T_2$ is exactly twice as large as the current in transistor $T_6$. Moreover, the voltage on the base of transistor $T_1$ is constant because a constant current of about I/2 flows through the series arrangement of the resistor $R_1$ and transistor $T_8$.

The value of the collector-emitter voltage of transistor $T_2$ depends on the resistance value of the resistor $R_1$ in conformity with equations (2) and (4). For a given value of the current this resistance value is selected in such a way that the voltage across this resistor is substantially lower than one base-emitter voltage. In a practical example of an arrangement with a supply voltage of 3V, and in which $I_1=100$ µA and $R_1=4$ kohms, this voltage and hence the collector-emitter voltage of transistor $T_2$ for the given ratio between the emitter areas is equal to 200 mV. This voltage is such that transistor $T_2$ is not saturated. For the lowest supply voltage of 1.6V at which the arrangement can operate the current $I_1=53$ µA when a current source $I_1$ is used whose current increases as a linear function of the supply voltage. The voltage across the resistor $R_1=4$ kohms and consequently the collector-emitter voltage of the transistor $T_2$ is then equal to 106 mV, which is high enough to ensure that transistor $T_2$ is not saturated. A major advantage of this low collector-emitter voltage of transistor $T_2$ is that the collector voltage of transistor $T_1$ is comparatively low. If a signal current is applied to the collector of transistor $T_2$, the collector of transistor $T_1$ can be driven to a lowest voltage equal to the collector-emitter voltage of the transistor $T_2$ plus one saturation voltage.

Another advantage of the arrangement is that a signal current may be applied to the collector of transistor $T_2$ without the collector-emitter voltage and consequently the collector current of the transistor $T_2$ varying significantly, because the collector-emitter voltage of transistor $T_2$ is equal to that of transistor $T_6$. The entire signal current appears on the collector of transistor $T_1$ without the collector-emitter voltage of transistor $T_2$ causing the collector current of the transistor $T_2$ to vary as a result of the Early effect.

The invention is not limited to the embodiment shown. For example, emitter-area ratios other than those given may be used. Further, one or more transistors may be arranged in parallel with the transistor $T_1$. Moreover, PNP transistors may be used instead of NPN transistors.

## Claims

1. A cascode current-source arrangement comprising a first ($T_1$) and a second ($T_2$) transistor whose collector-emitter paths are arranged in series between a first terminal (2) and a common second terminal (3) and a third transistor ($T_8$) connected as a diode, whose base is connected to the base of the second transistor ($T_2$) and whose emitter is connected to the common second terminal (3), characterized in that the arrangement further comprises a first input current path which comprises, between a third terminal (4) and the common second terminal (3), the series arrangement of a fourth transistor ($T_4$) connected as a diode, a diode ($T_5$) and the collector-emitter path of a fifth transistor ($T_6$), and a second current path which comprises, between the base of the fourth transistor ($T_4$) and the common second terminal (3), the series arrangement of the base-emitter path of a sixth transistor ($T_7$) having a collector coupled to a supply voltage terminal (5), a resistor ($R_1$) and the base-emitter path of the third transistor ($T_8$), whose base is further connected to the base of the fifth transistor ($T_6$), and the base of the first transistor ($T_1$) is connected to that end of the resistor ($R_1$) which is remote from the third transistor ($T_8$) such that the collector-emitter voltage of the fifth transistor ($T_6$) is substantially equal to the collector-emitter voltage of the second transistor ($T_2$).

2. A cascode current-source arrangement as claimed in Claim 1, characterized in that the diode ($T_5$) is a diode-connected transistor.

3. A cascode current-source arrangement as claimed in Claim 1 or 2, characterized in that the resistance value of the resistor ($R_1$) is selected so that the voltage across this resistor is smaller than the base-emitter voltage of a transistor.

**Patentansprüche**

1. Kaskodenstromquellenanordnung mit einem ersten (T1) und einem zweiten Transistor (T2), deren Kollektor-Emitterstrecken zwischen einer ersten Klemme (2) und einer gemeinsamen zweiten Klemme (3) in Reihe geschaltet sind, und mit einem dritten, als Diode verbundenen Transistor (T8), dessen Basis mit der Basis des zweiten Transistors (T2) und dessen Emitter mit der gemeinsamen zweiten Klemme (3) verbunden sind, dadurch gekennzeichnet, daß die Anordnung außerdem einen ersten Eingangsstromweg, der zwischen einer dritten Klemme (4) und der gemeinsamen zweiten Klemme (3) die Reihenschaltung eines vierten, als Diode verbundenen Transistors (T4), einer diode (T5) und der Kollektor-Emitterstrecke eines fünften Transistors (T6) enthält, und einen zweiten Stromweg enthält, der zwischen der Basis des vierten Transistors (T4) und der gemeinsamen zweiten Klemme (3) die Reihenschaltung der Basis-Emitterstrecke eines sechsten Transistors (T7) mit einem an die Speisespannungsklemme (5) gekoppelten Kollektor, eines Widerstands (R1) und der Basis-Emitterstrecke des dritten Transistors (T8) enthält, dessen Basis nach der Basis des fünften Transistors (T6) durchgeschaltet ist, und die Basis des ersten Transistors (T3) mit dem vom dritten Transistor (T8) abgewandten Ende des Widerstands (R1) derart verbunden ist, daß die Kollektor-Emitterspannung des fünften Transistors (T6) im wesentlichen gleich der Kollektor-Emitterspannung des zweiten Transistors (T2) ist.

2. Kaskodenstromquellenanordnung nach Anspruch 1, dadurch gekennzeichnet, daß die Diode (T5) ein als Diode geschalteter Transistor ist.

3. Kaskodenstromquellenanordnung nach Anspruch 1 oder 2, dadurch gekennzeichnet, daß der Widerstandswert des Widerstands (R1) so gewählt wird, daß die Spannung an diesem Widerstand kleiner ist als die Basis-Emitterspannung eines Transistors.

**Revendications**

1. Dispositif de source de courant en cascade muni d'un premier transistor ($T_1$) et d'un deuxième transistor ($T_2$), dont les trajets collecteur-émetteur sont montés en série entre une première borne (2) et une deuxième borne commune (3), et d'un troisième transistor ($T_8$) monté en diode, dont la base est connectée à la base du deuxième transistor ($T_2$) et dont l'émetteur est connecté à la deuxième borne commune (3), caractérisé en ce que le montage est en outre muni d'un premier trajet de courant d'entrée comportant, entre une troisième borne (4) et la deuxième borne commune (3), le montage en série d'un quatrième transistor ($T_4$) monté en diode, d'une diode ($T_5$) et du trajet collecteur-émetteur d'un cinquième transistor ($T_6$), et d'un deuxième trajet de courant comportant, entre la base du quatrième transistor ($T_4$) et la deuxième borne commune (3), le montage en série du trajet base-émetteur d'un sixième transistor ($T_7$) dont le collecteur est couplé à une borne de tension d'alimentation (5, d'une résistance ($R_1$) et du trajet base-émetteur du troisième transistor ($T_8$), dont la base est en outre connectée à la base du cinquième transistor ($T_6$), et en ce que la base du premier transistor ($T_1$) est connectée à l'extrémité de la résistance ($R_1$) éloignée du troisième transistor ($T_8$) de façon que la tension de collecteur-émetteur du cinquième transistor ($T_6$) soit pratiquement égale à la tension de collecteur-émetteur du deuxième transistor ($T_2$).

2. Dispositif de source de courant en cascade selon la revendication 1, caractérisé en ce que la diode ($T_5$) est un transistor monté en diode.

3. Dispositif de source de courant en cascade selon la revendication 1 ou 2, caractérisé en ce que la valeur ohmique de la résistance ($R_1$) est choisie de façon que la tension aux extrémités de cette résistance soit inférieure à la tension de base-émetteur d'un transistor.

4